# EUROPEAN PATENT SPECIFICATION

(11) **EP 2 946 444 B1**
(45) Date of publication and mention of the grant of the patent: **04.05.2022**
(21) Application number: 14702376.6
(22) Date of filing: 13.01.2014
(51) Int. Cl.: H01R 13/518, H01R 13/631, H01R 12/75, H01R 24/54, H01R 13/6583

(54) **ELECTRICAL CONNECTOR SYSTEM WITH BACKPLANE CONNECTOR AND DAUGHTERCARD CONNECTOR**
ELEKTRISCHES VERBINDERSYSTEM MIT VERBINDER FÜR EINE DAUGHTERCARD UND VERBINDER FÜR EINE RÜCKWANDPLATINE
SYSTÈME DE CONNECTEURS ÉLECTRIQUES AVEC DE CONNECTEUR DE CARTE FILLE ET DE CONNECTEUR DE FACE ARRIÈRE

(30) Priority: 21.01.2013 US 201313746086
(43) Date of publication of application: 25.11.2015
(73) Proprietor: TE Connectivity Corporation, Berwyn, PA 19312 (US)
(72) Inventor: MORLEY, Stephen Thomas, Manheim, Pennsylvania 17545 (US)
(74) Representative: Johnstone, Douglas Ian
(86) International application number: PCT/US2014/011191
(87) International publication number: WO 2014/113298

(56) References cited:
- EP-A1- 0 414 495
- EP-A2- 1 225 664
- US-A- 4 886 463
- US-A1- 2011 237 124
- US-B1- 6 776 621
- US-B1- 7 607 929
- US-B1- 8 002 574

## Description

The subject matter herein relates generally to electrical connector systems using daughtercard and backplane connectors.

Due to their favorable electrical characteristics, coaxial cables and connectors have grown in popularity for interconnecting electronic devices and peripheral systems. The connectors include an inner conductor coaxially disposed within an outer conductor, with a dielectric material separating the inner and outer conductors. A typical application utilizing coaxial cable connectors is a radio-frequency (RF) application having RF connectors designed to work at radio frequencies in the VLF through SHF range. RF connectors are typically used with coaxial cables and are designed to maintain the shielding that the coaxial design offers. US4886463 and US8002574 for example, disclose electrical connectors for mating coaxial cables. The connectors of US8002574 comprise a plurality of contact assemblies. Each set of contact assemblies of the connectors are terminated to the coaxial cables, and one set of the contact assemblies are float mounted to improve contact alignment between the connectors. US7607929 discloses electrical connector assemblies similar to those of US8002574, however, one connector is directly mounted to a circuit board rather than coaxial cables. EP1225664 discloses connectors directly mountable to circuit boards, the connectors having outer conductive tracks plated on a plastic molded housing with attachment pins connecting the tracks to the circuit board.

In a daughtercard/backplane application, known RF connectors typically use multiple RF contact assemblies in a single housing. The contact assemblies on the daughtercard side are float mounted and attached to free cables while the backplane contact assemblies are fixed coaxial cable assemblies. One drawback to such conventional arrangement is that both sets of the contact assemblies are cable mounted, which restricts the design density on the removable daughtercard.

The problem to be solved is a need for an electrical connector system that uses a configuration of daughtercard and backplane connectors that afford greater packaging flexibility for system designers.

The solution to the problem is provided by an electrical connector system as defined in the appended claim 1.

The invention will now be described by way of example with reference to the accompanying drawings in which:
Figure 1 illustrates an electrical connector system including a backplane connector and a daughtercard connector formed in accordance with an exemplary embodiment not covered by the claimed invention.
Figure 2 is a rear perspective view of a daughtercard connector
Figure 3 is an end view of the daughtercard connector.
Figure 4 is a front perspective view of a housing of the daughtercard connector.
Figure 5 is a front view of the housing.
Figure 6 is a side view of the housing.
Figure 7 is a cross-sectional view of the daughtercard connector taken along line 7-7 shown in Figures 3 and 5.
Figure 8 is a cross-sectional view of the daughtercard connector taken along line 8-8 shown in Figures 3 and 5.
Figure 9 is a front perspective view of a housing of the backplane connector that is used to hold a plurality of the backplane contact assemblies.
Figure 10 is a cross sectional view of the housing taken along line 10-10 shown in Figure 9.
Figure 11 is a perspective view of the backplane contact assembly.
Figure 12 is a cross sectional view of the backplane contact assembly.
Figure 13 is a cross sectional view of the connector system illustrating the daughtercard connector mated with the backplane connector.
Figure 14 illustrates a housing of a backplane connector for holding a plurality of backplane contact assemblies.
Figure 15 is a cross sectional view of the housing taken along line 15-15 shown in Figure 14.
Figure 16 is a cross sectional view of the backplane connector with the daughtercard connector coupled thereto forming an electrical connector system in accordance with the claimed invention.

In one embodiment, an electrical connector system is provided having a backplane connector and a daughtercard connector coupled to the backplane connector. The backplane connector includes a housing holding a plurality of backplane contact assemblies that are movable relative to the housing and each have a center contact and an outer shell surrounding the center contact configured to be terminated to coaxial cables. The daughtercard connector includes a housing holding a plurality of daughtercard contact assemblies coupled to corresponding backplane contact assemblies. The daughtercard contact assemblies are configured to be directly terminated to a daughtercard circuit board.

Optionally, the backplane contact assemblies may be spring loaded within the housing of the backplane connector to allow relative movement between the backplane contact assemblies and the housing of the backplane connector. The backplane contact assemblies may each have a spring surrounding the outer shell with a first end of the spring engaging the housing of the backplane connector and a second end of the spring engaging a retaining washer coupled to the shell. The spring may be captured between the housing of the backplane connector and the retaining washer and may be compressible to allow relative movement between the backplane contact assemblies and the housing of the backplane connector. Optionally, the backplane contact assemblies may be spring biased against corresponding daughtercard contact assemblies to maintain electrical connection therewith.

The backplane contact assemblies comprise mating interfaces internal of the housing of the backplane connector. The housing of the backplane connector include bores for receiving corresponding backplane contact assemblies and portions of corresponding daughtercard contact assemblies such that mating interfaces of the backplane contact assemblies and mating interfaces of the daughtercard contact assemblies are positioned within corresponding bores. In a background example not covered by the claimed invention, the daughtercard contact assemblies may be directly mated with corresponding backplane contact assemblies within the housing of the backplane connector. The backplane contact assemblies float within the housing of the backplane connector to align with and maintain electrical connection with the daughtercard contact assemblies.

The electrical connector system includes interconnects between corresponding backplane contact assemblies and daughtercard contact assemblies that create direct electrical paths between the backplane contact assemblies and the daughtercard contact assemblies. A conductive gasket that provides EMI/EMP shielding may be positioned between and directly engages both the housing of the backplane connector and the housing of the daughtercard connector.

The daughtercard contact assemblies includes contacts configured to be terminated to the daughtercard circuit board. The contacts may be held within the housing of the daughtercard connector and fixed in place relative to the housing of the daughtercard connector. The daughtercard contact assemblies include a mating contact and a board contact. The mating contact may be provided at a mating end of the housing of the daughtercard connector and the board contact may be provided at a mounting end of the housing of the daughtercard connector and mounted to the daughtercard circuit board. The board contact may be coupled to the mating contact within corresponding bores of the housing of the daughtercard connector. The board contact may extend from the housing of the daughtercard connector and may be terminated to the daughtercard circuit board.

Optionally, the housing of the daughtercard connector may include bores therein extending between mating and mounting ends of the housing of the daughtercard connector. The mating and mounting ends may be generally perpendicular to one another. The bores may include first and second segments oriented generally perpendicular to one another. The first segments may extend between the mating end and the second segment, while the second segment may extend between the mounting end and the first segment. The daughtercard contact assemblies may each include a mating contact received in the corresponding first segment and a board contact received in the corresponding second segment. The board contact may be coupled to the mating contact within corresponding bores generally at the intersection between the first and second segments.

Optionally, the electrical connector system may further include a second backplane connector, a backplane with the first and second backplane connectors coupled to the backplane, and a second daughtercard connector configured to be coupled to a second daughtercard circuit board. The first daughtercard connector and corresponding daughtercard circuit board may be mated with the first backplane connector, and the second daughtercard connector and corresponding second daughtercard circuit board may be mated with the second backplane connector.

In an embodiment provided for facilitating the understanding of the claimed subject matter, an electrical connector system is provided having a backplane connector including a housing having first and second faces and a bore extending between the first and second faces. The backplane connector includes a backplane contact assembly positioned in the bore of the housing and having a mating end being positioned internal to the bore and a cable end extending from the second face of the bore. The backplane contact assembly floats within the bore such that the mating end is movably positionable relative to the first and second faces. The electrical connector system includes a daughtercard connector including a housing having a mating end and a mounting end. The mating end is mated with the first face of the housing of the backplane connector. The mounting end is configured to be mounted to a daughtercard circuit board. The mounting end is generally perpendicular to the mating end. The housing has bores extending between the mating and mounting ends, and the daughtercard connector includes a daughtercard contact assembly positioned in the bores and having a mating contact provided at the mating end and a board contact provided at the mounting end. The board contact is coupled to the mating contact within at least one of the bores. The board contact extends from the housing and is configured to be terminated to the daughtercard circuit board.

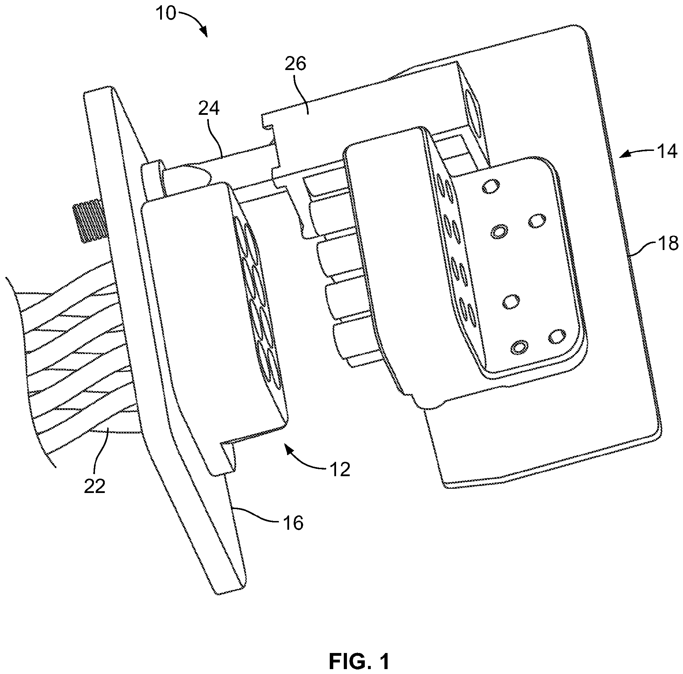

Figure 1 illustrates an electrical connector system 10 including a backplane connector 12 and a daughtercard connector 14 formed in accordance with an exemplary embodiment. The backplane connector 12 is mounted to a backplane 16, also referred to as a backplane circuit board 16, while the daughtercard connector 14 is mounted to a daughtercard 18, also referred to as a daughtercard circuit board 18. The daughtercard circuit board 18 is oriented generally perpendicular to the backplane 16.

In an exemplary embodiment, a plurality of the backplane connectors 12 may be mounted to the backplane 16 for interfacing with different daughtercards 18 and corresponding daughtercard connectors 14. For example, in a server/blade system, the backplane 16 may be mated with a plurality of blades defined by the daughtercards 18 and corresponding daughtercard connectors 14.

In an exemplary embodiment, the backplane and daughtercard connectors 12, 14 define radio frequency (RF) modules configured to convey multiple RF signals. In the illustrated embodiment, the daughtercard connector 14 is direct mounted to the daughtercard circuit board 18 (e.g. the conductor of the daughtercard connector 14 is directly connected to the daughtercard circuit board 18, such as by through-hole mounting, surface mounting, soldering and the like). In the illustrated embodiment, the backplane connector 12 includes a plurality of backplane contact assemblies 20 that are each cable mounted to corresponding coaxial cables 22 extending from the back end of the backplane connector 12.

Guides 24, 26 are used to guide mating of the daughtercard connector 14 with the backplane connector 12. For example, the guide 24 may be a pin received in a receptacle defined by the guide 26. The guides 24, 26 may allow blind mating of the daughtercard connector 14 with the backplane connector 12, such as by aligning the daughtercard connector 14 with the backplane connector 12 prior to mating.

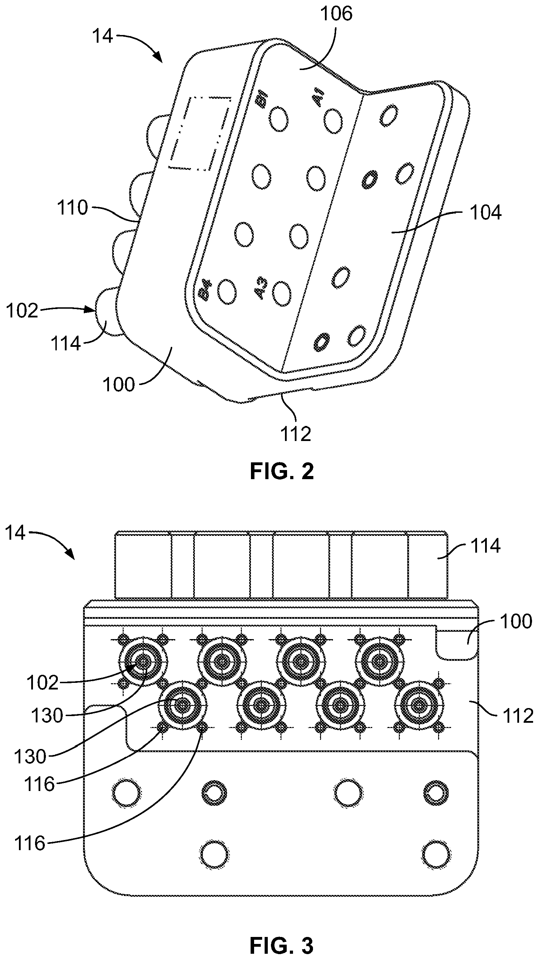

Figure 2 is a rear perspective view of the daughtercard connector 14 formed in accordance with an exemplary embodiment. The daughtercard connector 14 includes a daughtercard housing 100 holding a plurality of daughtercard contact assemblies 102. The housing 100 is electrically conductive and provides electrical shielding for signal conductors defined by the daughtercard contact assemblies 102. The housing 100 includes a mounting flange 104 extending rearward from a rear 106 of the main block of the housing 100 for supporting the housing 100 when mounted directly to the daughtercard circuit board 18 (shown in Figure 1).

The housing 100 includes a mating end 110 at a front of the housing 100 and a mounting end 112 at a bottom or side of the housing 100. The mating and mounting ends 110, 112 are generally perpendicular and allow the daughtercard circuit board 18 to be oriented perpendicular to the backplane 16 (shown in Figure 1).

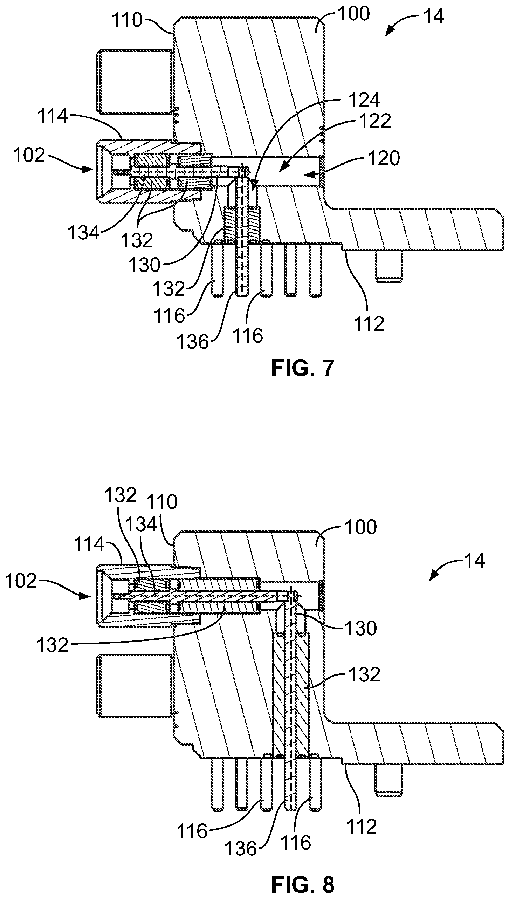

The daughtercard contact assemblies 102 define shielded RF contacts and generally include a center conductor 130 (shown in Figures 7 and 8) surrounded by an outer shield. The housing 100 forms part of the outer shield by surrounding the center conductor 130, which is routed internal of the housing 100 between the mating end 110 and the mounting end 112. The daughtercard contact assemblies 102 include front shells 114 extending forward of the front of the housing 100 at the mating end 110. The front shells 114 define portions of the outer shield and surround portions of the center conductor 130. The front shells 114 are configured to be received in the backplane connector 12 (shown in Figure 1) when mated thereto. The front shells 114 may be separate and discrete pieces mechanically and electrically coupled to the housing 100. Alternatively, the front shells 114 may be formed integral with the housing 100.

Figure 3 is an end view of the daughtercard connector 14, showing the mounting end 112 of the housing 100. The front shells 114 extend forward from the mating end 110 of the housing 100. Figure 3 illustrates portions of the center conductors 130 (shown in further detail in Figures 7 and 8) of the daughtercard contact assemblies 102. For example, pins are illustrated in Figure 3, which are configured to be through-hole mounted to the daughtercard circuit board 18 (shown in Figure 1). Other types of interfaces may be provided in alternative embodiments for directly connecting the daughtercard contact assemblies 102 to the daughtercard circuit board 18.

The daughtercard connector 14 includes a plurality of ground pins 116 extending from the mounting end 112. The ground pins 116 are configured to be terminated to the daughtercard circuit board 18, such as by through hole mounting to corresponding ground vias in the daughtercard circuit board 18. The ground pins 116 electrically connect the housing 100 to a ground plane of the daughtercard circuit board 18. Multiple ground pins 116 surround each of the center conductors 130 to enhance electrical shielding around the center conductors 130. Any number of ground pins 116 may be used. Optionally, some of the ground pins 116 may be shared by adjacent center conductors 130.

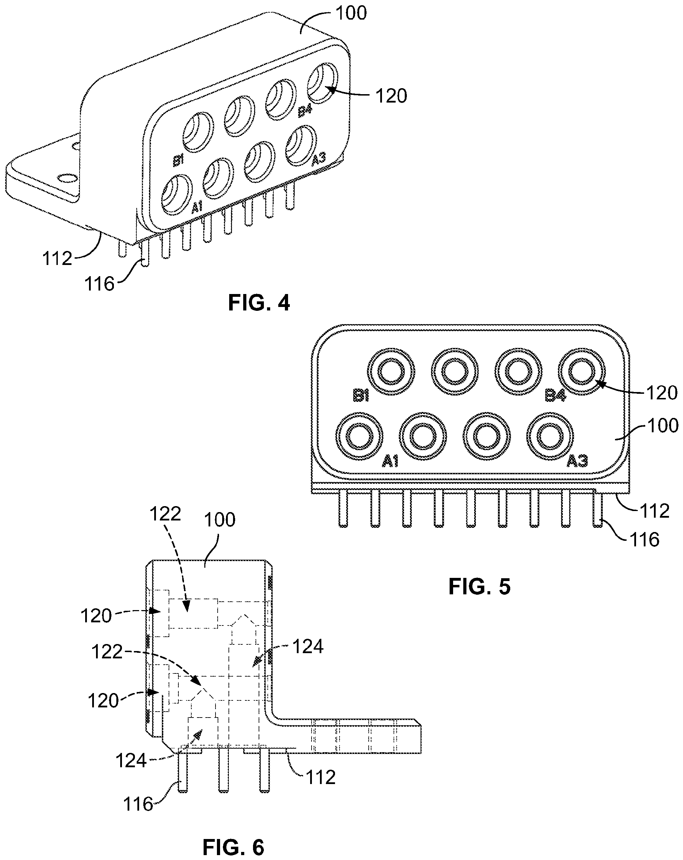

Figure 4 is a front perspective view of the housing 100. Figure 5 is a front view of the housing 100. Figure 6 is a side view of the housing 100. The ground pins 116 are shown extending from the mounting end 112.

The housing 100 includes a plurality of bores 120 extending therethrough between the mating end 110 and the mounting end 112. The center conductors 130 are configured to be received in and routed through the bores 120. At the mating end 110, the bores 120 are sized and shaped to receive the front shells 114 (shown in Figure 2). Optionally, the bores 120 may hold the front shells 114 by an interference fit. In an exemplary embodiment, the bores 120 are right angle bores extending in two generally perpendicular directions. For example, the bores 120 may each include a first segment 122 and second segment 124 oriented generally perpendicular to one another. The first segments 122 extend between the mating end 110 and the corresponding second segment 124. Optionally, the first segments 122 may extend beyond the second segments 124 to the rear 106, such as to allow loading into the bores 120 from the rear 106. The first segments 122 may be capped at the rear 106 with caps or plugs. The second segments 124 extend between the mounting end 112 and the corresponding first segment 122. The first and second segments 122, 124 of different bores 120 may be staggered (e.g. front and rear; top and bottom; and/or side to side) to allow tighter placement of the daughtercard contact assemblies 102 (shown in Figure 2).

Figure 7 is a cross-sectional view of the daughtercard connector 14 taken along line 7-7 shown in Figures 3 and 5. Figure 8 is a cross-sectional view of the daughtercard connector 14 taken along line 8-8 shown in Figures 3 and 5. Figures 7 and 8 show cross-sections taken along different daughtercard contact assemblies 102.

Each daughtercard contact assembly 102 includes the front shell 114, the center conductor 130 and insulators 132 used to support the center conductor 130 in the housing 100 and/or the front shell 114. The insulators 132 are manufactured from a dielectric material, such as a plastic material. The insulators 132 position the center conductor 130 at a predetermined spacing from the housing 100 and/or the front shell 114, such as to control the impedance along the signal path.

The center conductor 130 is formed from two contact pieces that are mechanically and electrically coupled together within the housing 100. The center conductor 130 includes a mating contact 134 and a board contact 136. The mating contact 134 is provided at the mating end 110 of the housing 100. The mating contact 134 is configured to be electrically connected to the backplane connector 12 (shown in Figure 1). The board contact 136 is provided at the mounting end 112 of the housing 100. The board contact 136 is configured to be mounted to the daughtercard circuit board 18 (shown in Figure 1). The board contact 136 extends from the housing 100 and is configured to be terminated to the daughtercard circuit board 18, such as by through hole mounting to the daughtercard circuit board 18 when received in a via of the daughtercard circuit board 18. The exposed portion of the board contact 136 may define a pin, such as a compliant pin or an action pin. The ground pins 116 surround the board contact 136.

In an exemplary embodiment, the board contact 136 is oriented generally perpendicular to the mating contact 134. The board contact 136 is coupled to the mating contact 134 within corresponding bore 120 generally at the intersection between the first and second segments 122, 124. The board contact 136 is coupled to the mating contact 134 using a pin and socket type of connection, however other types of interfaces may be used in alternative embodiments to mechanically and electrically connect the board contact 136 and the mating contact 134.

During assembly, the front shell 114, insulators 132 and contacts 134, 136 may be loaded into the bores 120 and held in the housing 100 once positioned. For example, the front shell 114 may be loaded into the housing 100 through the mating end 110. Some of the insulators 132 are loaded into the front shells 114, some of the insulators 132 are loaded into the first segments 122 of the bores 120 and some of the insulators 132 are loaded into the second segments 124 of the bores 120. The insulators 132 may be preloaded into position prior to loading the contacts 134, 136 into the corresponding insulators 132, or alternatively, the contacts 134, 136 may be loaded into the insulators 132 and then loaded as a unit into the housing 100.

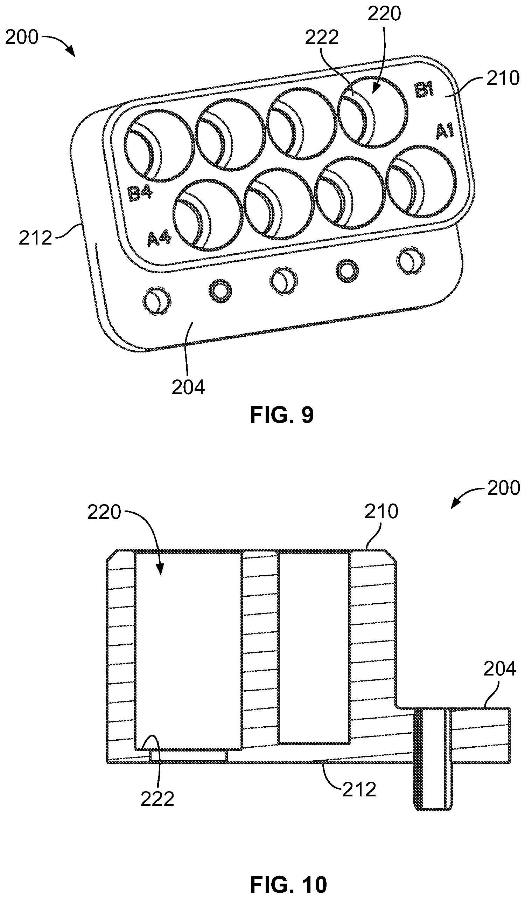

Figure 9 is a front perspective view of a backplane housing 200 of the backplane connector 12 (shown in Figure 1) that is used to hold a plurality of the backplane contact assemblies 20 (shown in Figure 1). Figure 10 is a cross sectional view of the housing 200 taken along line 10-10 shown in Figure 9. The housing 200 is electrically conductive and provides electrical shielding for signal conductors defined by the backplane contact assemblies 20. The housing 200 includes a mounting flange 204 extending from the main block of the housing 200 for supporting the housing 200 when mounted directly to the backplane 16 (shown in Figure 1).

The housing 200 includes a mating end 210 at a front of the housing 200 and a mounting end 212 at a rear of the housing 200. The mating end 210 is configured to be mated to the daughter card connector 14 (shown in Figure 1). The mounting end 212 is configured to be mounted to the backplane 16. The mating and mounting ends 210, 212 are generally parallel and allow the backplane contact assemblies 20 to pass straight through the housing 200.

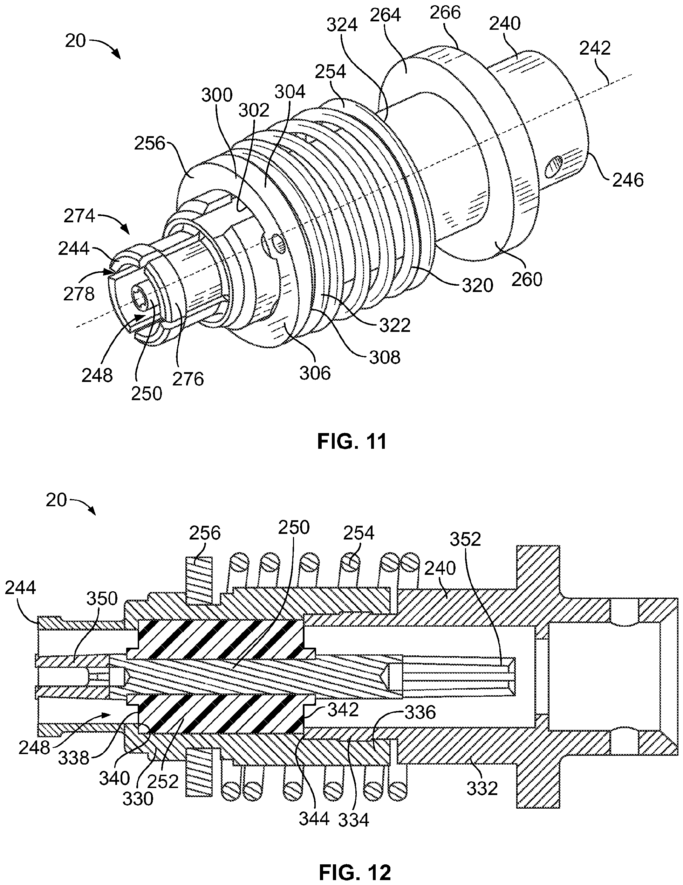

The housing 200 forms part of an outer shield for the backplane contact assemblies 20 by surrounding the center contacts 250 (shown in Figure 11). The housing 200 includes a plurality of bores 220 extending therethrough between the mating end 210 and the mounting end 212. The backplane contact assemblies 20 are configured to be received in corresponding bores 220. In an exemplary embodiment, the bores 220 are cylindrical and pass straight through the housing 200 with a flange or lip 222 at the mounting end 212 used to hold the backplane contact assemblies 20 in the bores 220.

Figure 11 is a perspective view of the backplane contact assembly 20. Figure 12 is a cross sectional view of the backplane contact assembly 20. The backplane contact assembly 20 includes a shell 240 extending along a central longitudinal axis 242 between a mating end 244 and a cable end 246. The shell 240 defines a shell cavity 248. The backplane contact assembly 20 includes a center contact 250 held within the shell cavity 248. In an exemplary embodiment, a dielectric body 252 (shown in Figure 12) is positioned between the shell 240 and the contact 250. In an exemplary embodiment, the shell 240 is formed from a conductive material, such as a metal material, and the dielectric body 252 electrically separates the contact 250 and the shell 240. The backplane contact assembly 20 includes a spring 254 concentrically surrounding a portion of the shell 240. The backplane contact assembly 20 includes a retaining washer 256 used to retain the spring 254 in position with respect to the shell 240.

The shell 240 is generally cylindrical in shape. A flange 260 extends radially outward from the shell 240. The flange 260 is positioned proximate the cable end 246. In the illustrated embodiment, the flange 260 is positioned a distance from the mating end 244. The flange 260 includes a forward facing surface 264 and a rear facing surface 266. The surfaces 264, 266 are generally perpendicular with respect to the longitudinal axis 242.

The shell 240 is tapered or stepped at the mating end 244 such that a shell diameter at the mating end 244 is smaller than along other portions of the shell 240. The shell 240 includes a tip portion 274 configured to be received within the front shell 114 of the daughtercard contact assembly 102 (both shown in Figure 7). In an exemplary embodiment, the tip portion 274 includes a plurality of segments 276 that are separated by gaps 278. The segments 276 are movable with respect to one another such that the segments 276 may be deflected toward one another to reduce the diameter of the tip portion 274 for mating with the daughtercard contact assembly 102. Deflection of the segments 276 may cause a friction fit with the front shell 114 when mated.

The washer 256 includes a ring-shaped body 300 having a radially inner surface 302 and a radially outer surface 304. The washer 256 includes a forward facing surface 306 and a rear engagement surface 308.

The spring 254 has a helically wound body 320 extending between a front end 322 and a rear end 324. The rear end 324 faces the forward facing surface 264 of the flange 260. The spring 254 is loaded over the mating end 244 and concentrically surrounds a portion of the shell 240. The spring 254 has a spring diameter that is greater than the shell diameter. The spring 254 is compressible axially.

During assembly, the retaining washer 256 is loaded onto the mating end 244 of the shell 240 and holds the spring 254 in position relative to the shell 240. The rear engagement surface 308 of the washer 256 engages the front end 322 of the spring 254. Optionally, the washer 256 may at least partially compress the spring 254 such that the spring is biased against the washer 256.

In an exemplary embodiment, as shown in Figure 12, the shell 240 includes a front shell 330 and a rear shell 332. A nose 334 of the rear shell 332 is received in a hood 336 of the front shell 330. The dielectric body 252 is held within the shell cavity 248. For example, a front end 338 of the dielectric body 252 engages a lip 340 of the front shell 330 proximate to the mating end 244. A rear end 342 of the dielectric body 252 engages a front surface 344 of the rear shell 332. The dielectric body 252 is captured in the front shell 330 by the rear shell 332.

The contact 250 is held within the shell cavity 248 by the dielectric body 252. The contact 250 includes a mating end 350 and a terminating end 352. The mating end 350 is configured to mate with the corresponding mating contact 134 (shown in Figures 7 and 8) of the daughtercard contact assembly 102. The mating end 350 is positioned proximate to the mating end 244 of the shell 240. The terminating end 352 is configured to be terminated to a cable, such as, to a center conductor (not shown) of a coaxial cable. The rear shell 332 is configured to mechanically and/or electrically connected to the cable, such as, to the cable braid, the cable insulator and/or the cable jacket.

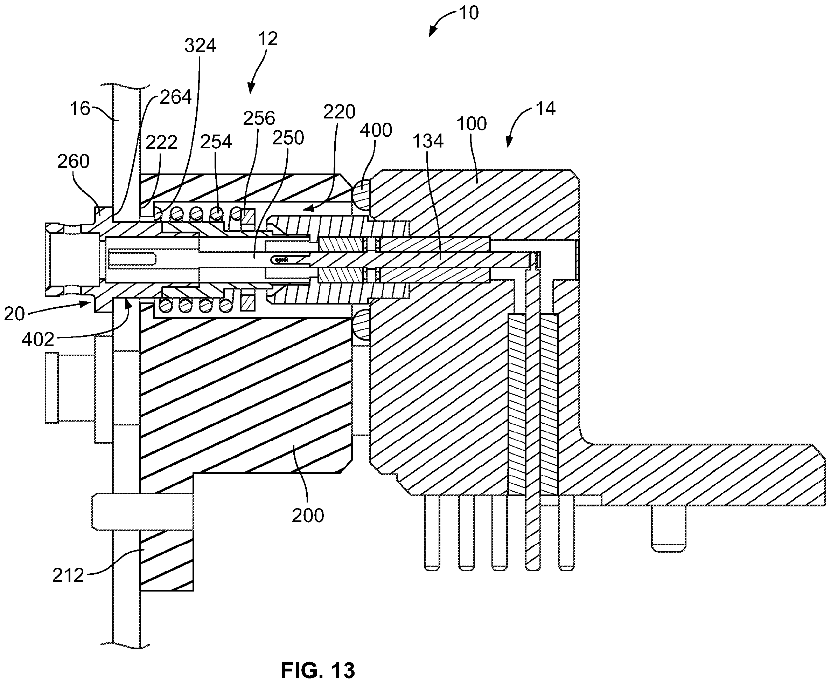

Figure 13 is a cross sectional view of the connector system 10 illustrating, for the purposes of facilitating the understanding of the claimed subject matter, the daughtercard connector 14 mated with the backplane connector 12. The center contacts 250 are mated with the corresponding mating contacts 134. In an exemplary embodiment a gasket 400 is positioned between the housings 100, 200. The gasket 400 reduces and/or eliminates EMI leakage into or from the electrical connector system 10 through the mating interface between the backplane connector 12 and the daughtercard connector 14.

The backplane contact assemblies 20 are illustrated within the bores 220 of the housing 200. The spring 254 is positioned between the housing 200 and the retaining washer 256. The rear end 324 of the spring 254 engages the lip 222 extending into the bore 220 at the mounting end 212 of the housing 200. The spring is compressed between the lip 222 and the retaining washer 256. The spring 254 may be compressed to allow the backplane contact assembly 20 to move relative to the housing 200. The backplane contact assembly 20 is able to float within the housing 200, such as during mating with the daughtercard connector 14. Optionally, the backplane contact assembly 20 may be capable of floating in 3-dimensions (e.g. front to back; top to bottom; and/or side to side). The floating may allow proper alignment with the daughtercard connector 14 during mating. The spring 254 maintains spring pressure in a forward direction against the daughtercard connector 14 to ensure mating engagement between the center contact 250 and the mating contact 134.

The housing 200 is illustrated mounted to the backplane 16. In the illustrated embodiment, the rear of the mounting end 212 is mounted to the backplane 16, while a portion of each backplane contact assembly 20 extends through corresponding openings 402 in the backplane 16. The flange 260 is captured at the back side of the backplane 16. The forward facing surface 264 of the flange 260 faces the backplane 16. The spring pressure of the spring 254 may hold the flange 260 against the backplane 16. The flange 260 may be pressed away from the backplane 16 when the spring 254 is compressed, such as during mating with the daughtercard connector 14.

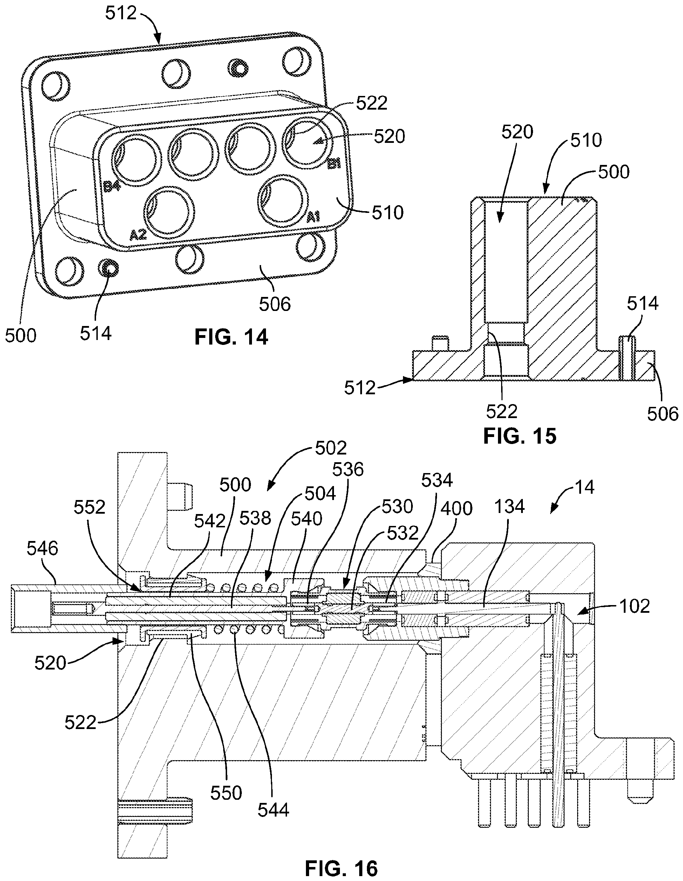

Figure 14 illustrates a housing 500 of a backplane connector 502 (shown in Figure 16) for holding a plurality of backplane contact assemblies 504 (shown in Figure 16). Figure 15 is a cross sectional view of the housing 500 taken along line 15-15 shown in Figure 14. The housing 500 is electrically conductive and provides electrical shielding for signal conductors defined by the backplane contact assemblies 504. The housing 500 includes a mounting flange 506 extending from the main block of the housing 500 for supporting the housing 500 when mounted directly to a backplane.

The housing 500 includes a mating end 510 at a front of the housing 500 and a mounting end 512 at a rear of the housing 500. The mounting flange 506 is provided at the mounting end 512. The mounting end 512 is configured to be mounted to the backplane 16. The mating end 510 is configured to be mated to the daughter card connector 14 (shown in Figure 1). The mating and mounting ends 510, 512 are generally parallel and allow the backplane contact assemblies 504 to pass straight through the housing 500. Optionally mounting pins 514 may extend from the mounting flange 506 to secure locate the housing 500 relative to the backplane. In the illustrated embodiment, the mounting pins 514 extend forward of the mounting flange 506. The front of the mounting flange 506 is pressed against the backplane when mounted thereto.

The housing 500 forms part of an outer shield for the backplane contact assemblies 504. The housing 500 includes a plurality of bores 520 extending therethrough between the mating end 510 and the mounting end 512. The backplane contact assemblies 504 are configured to be received in corresponding bores 520. In an exemplary embodiment, the bores 520 are cylindrical and pass straight through the housing 500 with a flange or lip 522 proximate to the mounting end 512 used to hold the backplane contact assemblies 504 in the bores 520.

Figure 16 is a cross sectional view of the backplane connector 502 with the daughtercard connectors 14 coupled thereto. The backplane connector includes the housing 500 and the backplane contact assemblies 504 received in the bores 520. Portions of the daughtercard connector 14 are received in the housing 500 to mate with the backplane contact assemblies 504. The gasket 400 is provided at the interface between the daughtercard connector 14 and the backplane connector 502.

Interconnects 530 are positioned in the bores 520 between corresponding backplane contact assemblies 504 and daughtercard contact assemblies 102. The interconnects 530 create direct electrical paths between the backplane contact assemblies 504 and the daughtercard contact assemblies 102. The interconnect 530 includes an interconnect contact 532 having opposed mating ends 534, 536 that interface with the mating contact 134 and a center contact 538 of the backplane contact assembly 504. In the illustrated embodiment, the mating ends 534, 536 are sockets configured to receive pins defined at mating ends of the mating contact 134 and the center contact 538.

The backplane contact assembly 504 includes an outer shell 540 and an insulator 542 held within the outer shell 540. The insulator 542 holds the center contact 538. The outer shell 540 provides shielding for the center contact 538. A spring 544 surrounds the outer shell 540 and allows relative movement of the backplane contact assembly 504 with respect to the housing 500. The backplane contact assembly 504 is terminated to an end of a cable 546, which extends from the backplane connector 502 beyond the backplane.

In an exemplary embodiment, a retainer 550 is used to hold the backplane contact assembly 504 within the housing 500. The retainer 550 is secured to the lip 522. The retainer 550 includes an opening 552 through which a portion of the backplane contact assembly 504 extends. The backplane contact assembly 504 is movable within the opening 552. The retainer 550 is used to retain the spring 544 and the spring is compressible against the retainer 550.

## Claims

1. An electrical connector system (10) comprising:
a backplane connector (502) including a housing (500) comprising bores (520) and a plurality of backplane contact assemblies (504), the housing configured to hold the plurality of backplane contact assemblies (504) within corresponding bores (520), the backplane contact assemblies being movable relative to the housing defining float mounted contact assemblies, the backplane contact assemblies each having a center contact (538) and an outer shell (540) surrounding the center contact, the backplane contact assemblies being configured to be terminated to coaxial cables;
a daughtercard connector (14) coupled to the backplane connector, the daughtercard connector (14) being configured to be mounted to a daughtercard circuit board (18), the daughtercard connector (14) comprising a plurality of daughtercard contact assemblies (102) and a housing (100) holding the plurality of daughtercard contact assemblies (102), wherein each daughtercard contact assembly (102) includes a center conductor (130, 134) including a mating contact (134) and a board contact (136), is coupled to a corresponding backplane contact assembly (504) and is configured to be directly terminated to the daughtercard circuit board (18), the housing (100) of the daughtercard connector (14) being electrically conductive and having a plurality of ground pins (116) extending from a mounting end of the housing of the daughtercard connector, (112) wherein multiple of said ground pins (116) surround each of the center conductors (130) of the daughtercard contact assemblies (102) to enhance electrical shielding around the center conductors (130) and are configured to be terminated to the daughtercard circuit board (18), the ground pins (116) configured to electrically connect the housing (100) to a ground plane of the daughtercard circuit board (18);
wherein the connector system further includes a plurality of interconnects (530) positioned in bores (520) of the backplane connector (502) between corresponding backplane contact assemblies and daughtercard contact assemblies, , each interconnect comprising an interconnect contact (532) having opposed mating ends (534, 536) which interface with the mating contact (134) and a center contact (538) such that the interconnects create a direct electrical path between the backplane contact assemblies and the daughtercard contact assemblies, the bores (520) further receive portions of corresponding daughtercard assemblies such that mating interfaces of the backplane contact assemblies (504) and mating interfaces of the daughtercard assemblies (102) are positioned within corresponding bores (520).

2. The electrical connector system (10) of claim 1, wherein the backplane contact assemblies (504) are spring loaded within the housing (500) of the backplane connector to allow relative movement between the backplane contact assemblies and the housing of the backplane connector.

3. The electrical connector system (10) of claim 1, wherein the backplane contact assemblies (504) each comprise a spring (544) surrounding the outer shell (540), a first end of the spring engaging the housing (500) of the backplane connector, a second end of the spring engaging a retaining washer coupled to the shell (540), the spring being captured between the housing of the backplane connector and the retaining washer and being compressible to allow relative movement between the backplane contact assemblies and the housing of the backplane connector.

4. The electrical connector system (10) of claim 1, wherein the backplane contact assemblies (504) each have mating interfaces internal of the housing (500) of the backplane connector (502).

5. The electrical connector system (10) of claim 1, wherein the daughtercard contact assemblies (102) are directly mated with corresponding backplane contact assemblies (504) within the housing (500) of the backplane connector (12), the backplane contact assemblies floating within the housing of the backplane connector to align with and maintain electrical connection with the daughtercard contact assemblies.

6. The electrical connector system (10) of claim 1, wherein the backplane contact assemblies (504) are spring biased against corresponding daughtercard contact assemblies (102) to maintain electrical connection therewith.

7. The electrical connector system (10) of claim 1, further comprising a gasket (400) between and directly engaging both the housing (500) of the backplane connector (502) and the housing (100) of the daughtercard connector (14).

8. The electrical connector system (10) of claim 1, wherein electrical paths are created between the coaxial cables and the daughtercard circuit board (18) via the backplane contact assemblies (504) and the daughtercard contact assemblies (102).

9. The electrical connector system (10) of claim 1, wherein the center conductors (130) are held within the housing of the daughtercard connector (14) and fixed in place relative to the housing of the daughtercard connector.

10. The electrical connector system (10) of claim 1, the mating contact (134) being provided at the mating end (112) of the housing (100) of the daughtercard connector (14), the board contact being provided at the mounting end (112) of the housing of the daughtercard connector configured to be mounted to the daughtercard circuit board and oriented generally perpendicular to the mating end, the board contact being coupled to the mating contact within corresponding bores (120) of the housing of the daughtercard connector, the board contact extending from the housing of the daughtercard connector and being configured to be terminated to the daughtercard circuit board.

11. The electrical connector system (10) of claim 1, wherein the housing of the daughtercard connector includes bores (120) therein extending between mating and mounting ends (110, 112) of the housing of the daughtercard connector, the mating and mounting ends being generally perpendicular to one another, the bores including first and second segments (122, 124) oriented generally perpendicular to one another, the first segments extending between the mating end and the second segment, the second segment extending between the mounting end and the first segment, the daughtercard contact assemblies each include a mating contact (134) received in the corresponding first segment and a board contact (136) received in the corresponding second segment, the board contact being coupled to the mating contact within corresponding bores generally at the intersection between the first and second segments.

## Patentansprüche

1. Elektrisches Verbindersystem (10), das Folgendes umfasst:
einen Rückwandverbinder (502) mit einem Gehäuse (500), das Bohrungen (520) und mehrere Rückwand-Kontaktbaugruppen (504) umfasst, wobei das Gehäuse zum Halten der mehreren Rückwand-Kontaktbaugruppen (504) in entsprechenden Bohrungen (520) konfiguriert ist, wobei die Rückwand-Kontaktbaugruppen relativ zum Gehäuse beweglich sind und schwebend gelagerte Kontaktbaugruppen definieren, wobei die Rückwand-Kontaktbaugruppen jeweils einen Mittelkontakt (538) und einen den Mittelkontakt umgebenden Außenmantel (540) aufweisen, wobei die Rückwand-Kontaktbaugruppen zum Abschließen auf Koaxialkabel konfiguriert sind;
einen Tochterkartenverbinder (14), der mit dem Rückwandverbinder gekoppelt ist, wobei der Tochterkartenverbinder (14) zum Montieren an einer Tochterkartenleiterplatte (18) konfiguriert ist, wobei der Tochterkartenverbinder (14) mehrere Tochterkarten-Kontaktbaugruppen (102) und ein Gehäuse (100) umfasst, das die mehreren Tochterkarten-Kontaktbaugruppen (102) hält, wobei jede Tochterkarten-Kontaktbaugruppe (102) einen Mittelleiter (130, 134) mit einem Steckkontakt (134) und einem Plattenkontakt (136) aufweist, mit einer entsprechenden Rückwand-Kontaktbaugruppe (504) gekoppelt und zum direkten Abschließen an der Tochterkartenleiterplatte (18) konfiguriert ist, wobei das Gehäuse (100) des Tochterkartenverbinders (14) elektrisch leitend ist und mehrere Erdungsstifte (116) aufweist, die sich von einem Montageende des Gehäuses des Tochterkartenverbinders (112) erstrecken, wobei mehrere der genannten Erdungsstifte (116) jeden der Mittelleiter (130) der Tochterkarten-Kontaktbaugruppen (102) umgeben, um die elektrische Abschirmung um die Mittelleiter (130) zu verbessern, und zum Abschließen an der Tochterkartenleiterplatte (18) konfiguriert sind, wobei die Erdungsstifte (116) zum elektrischen Verbinden des Gehäuses (100) mit einer Grundplatte der Tochterkartenleiterplatte (18) konfiguriert sind;
wobei das Verbindersystem ferner mehrere Zwischenverbindungen (530) umfasst, die in Bohrungen (520) des Rückwandverbinders (502) zwischen entsprechenden Rückwand-Kontaktbaugruppen und Tochterkarten-Kontaktbaugruppen positioniert sind, wobei jede Zwischenverbindung einen Zwischenverbindungskontakt (532) mit gegenüberliegenden Steckenden (534, 536), die eine Schnittstelle mit dem Steckkontakt (134) bilden, und einen Mittelkontakt (538) umfasst, so dass die Zwischenverbindungen einen direkten elektrischen Pfad zwischen den Rückwand-Kontaktbaugruppen und den Tochterkarten-Kontaktbaugruppen erzeugen, wobei die Bohrungen (520) ferner Teile entsprechender Tochterkartenbaugruppen aufnehmen, so dass Steckschnittstellen der Rückwand-Kontaktbaugruppen (504) und Steckschnittstellen der Tochterkartenbaugruppen (102) innerhalb entsprechender Bohrungen (520) positioniert sind.

2. Elektrisches Verbindersystem (10) nach Anspruch 1, wobei die Rückwand-Kontaktbaugruppen (504) innerhalb des Gehäuses (500) des Rückwandverbinders federbelastet sind, um eine relative Bewegung zwischen den Rückwand-Kontaktbaugruppen und dem Gehäuse des Rückwandverbinders zu ermöglichen.

3. Elektrisches Verbindersystem (10) nach Anspruch 1, wobei die Rückwand-Kontaktbaugruppen (504) jeweils eine den Außenmantel (540) umgebende Feder (544) umfassen, wobei ein erstes Ende der Feder in das Gehäuse (500) des Rückwandverbinders eingreift, wobei ein zweites Ende der Feder in eine mit dem Mantel (540) gekoppelte Haltescheibe eingreift, wobei die Feder zwischen dem Gehäuse des Rückwandverbinders und der Haltescheibe festgehalten wird und komprimierbar ist, um eine relative Bewegung zwischen den Rückwand-Kontaktbaugruppen und dem Gehäuse des Rückwandverbinders zu ermöglichen.

4. Elektrisches Verbindersystem (10) nach Anspruch 1, wobei die Rückwand-Kontaktbaugruppen (504) jeweils Steckschnittstellen innerhalb des Gehäuses (500) des Rückwandsteckers (502) aufweisen.

5. Elektrisches Verbindersystem (10) nach Anspruch 1, wobei die Tochterkarten-Kontaktbaugruppen (102) direkt mit entsprechenden Rückwand-Kontaktbaugruppen (504) innerhalb des Gehäuses (500) des Rückwandverbinders (12) zusammengesteckt sind, wobei die Rückwand-Kontaktbaugruppen innerhalb des Gehäuses des Rückwandverbinders schweben, um sich mit den Tochterkarten-Kontaktbaugruppen auszurichten und eine elektrische Verbindung damit beizubehalten.

6. Elektrisches Verbindersystem (10) nach Anspruch 1, wobei die Rückwand-Kontaktbaugruppen (504) gegen entsprechende Tochterkarten-Kontaktbaugruppen (102) federnd vorgespannt sind, um eine elektrische Verbindung mit diesen beizubehalten.

7. Elektrisches Verbindersystem (10) nach Anspruch 1, das ferner eine Dichtung (400) zwischen und im direkten Eingriff mit dem Gehäuse (500) des Rückwandverbinders (502) und dem Gehäuse (100) des Tochterkartenverbinders (14) aufweist.

8. Elektrisches Verbindersystem (10) nach Anspruch 1, wobei elektrische Pfade zwischen den Koaxialkabeln und der Tochterkarten-Leiterplatte (18) über die Rückwand-Kontaktbaugruppen (504) und die Tochterkarten-Kontaktbaugruppen (102) erzeugt werden.

9. Elektrisches Verbindersystem (10) nach Anspruch 1, wobei die Mittelleiter (130) innerhalb des Gehäuses des Tochterkartenverbinders (14) gehalten und relativ zum Gehäuse des Tochterkartenverbinders fixiert sind.

10. Elektrisches Verbindersystem (10) nach Anspruch 1, wobei der Steckkontakt (134) am Steckende (112) des Gehäuses (100) des Tochterkartenverbinders (14) vorgesehen ist, wobei der Plattenkontakt am Montageende (112) des Gehäuses des Tochterkartenverbinders vorgesehen ist, das zum Montieren an der Tochterkartenleiterplatte konfiguriert und allgemein lotrecht zum Steckende ausgerichtet ist, wobei der Plattenkontakt mit dem Steckkontakt innerhalb entsprechender Bohrungen (120) des Gehäuses des Tochterkartenverbinders gekoppelt ist, wobei sich der Plattenkontakt vom Gehäuse des Tochterkartenverbinders erstreckt und zum Abschließen an der Tochterkartenleiterplatte konfiguriert ist.

11. Elektrisches Verbindersystem (10) nach Anspruch 1, wobei das Gehäuse des Tochterkartenverbinders Bohrungen (120) darin aufweist, die sich zwischen einem Steck- und einem Montageende (110, 112) des Gehäuses des Tochterkartenverbinders erstrecken, wobei das Steck- und das Montageende allgemein lotrecht zueinander sind, wobei die Bohrungen ein erstes und ein zweites Segment (122, 124) aufweisen, die allgemein lotrecht zueinander ausgerichtet sind, wobei sich die ersten Segmente zwischen dem Steckende und dem zweiten Segment erstreckt, die ersten Segmente sich zwischen dem Steckende und dem zweiten Segment erstrecken, das zweite Segment sich zwischen dem Montageende und dem ersten Segment erstreckt, die Tochterkarten-Kontaktbaugruppen jeweils einen im entsprechenden ersten Segment aufgenommenen Steckkontakt (134) und einen im entsprechenden zweiten Segment aufgenommenen Plattenkontakt (136) umfassen, wobei der Plattenkontakt mit dem Steckkontakt innerhalb entsprechender Bohrungen allgemein am Schnittpunkt zwischen dem ersten und dem zweiten Segment gekoppelt ist.

## Revendications

1. Système de connecteur électrique (10) comprenant :
un connecteur de face arrière (502) incluant un logement (500) comprenant des alésages (520) et une pluralité d'ensembles de contact de face arrière (504), le logement étant configuré pour maintenir la pluralité d'ensembles de contact de face arrière (504) au sein d'alésages correspondants (520), les ensembles de contact de face arrière étant mobiles relativement au logement définissant des ensembles de contact en montage flottant, les ensembles de contact de face arrière ayant chacun un contact central (538), et une coque externe (540) entourant le contact central, les ensembles de contact de face arrière étant configurés pour être terminés sur des câbles coaxiaux ;
un connecteur de carte fille (14) couplé au connecteur de face arrière, le connecteur de carte fille (14) étant configuré pour être monté sur une carte à circuits de carte fille (18), le connecteur de carte fille (14) comprenant une pluralité d'ensembles de contact de carte fille (102) et un logement (100) maintenant la pluralité d'ensembles de contact de carte fille (102), dans lequel chaque ensemble de contact de carte fille (102) inclut un conducteur central (130, 134) incluant un contact d'accouplement (134) et un contact de carte (136) est couplé à un ensemble de contact de face arrière correspondant (504) et est configuré pour être directement terminé sur la carte à circuits de carte fille (18), le logement (100) du connecteur de carte fille (14) étant électriquement conducteur et ayant une pluralité de broches de masse (116) s'étendant à partir d'une extrémité de montage du logement du connecteur de carte fille (112), dans lequel de multiples broches desdites broches de masse (116) entourent chacun des conducteurs centraux (130) des ensembles de contact de carte fille (102) afin d'améliorer le blindage électrique autour des conducteurs centraux (130) et sont configurées pour être terminées sur la carte à circuits de carte fille (18), les broches de masse (116) étant configurées pour connecter électriquement le logement (100) au plan de masse de la carte à circuits de carte fille (18) ;
dans lequel le système de connecteur inclut en outre une pluralité d'interconnexions (530) positionnées dans des alésages (520) du connecteur de face arrière (502) entre des ensembles de contact de face arrière et des ensembles de contact de carte fille correspondants, chaque interconnexion comprenant un contact d'interconnexion (532) ayant des extrémités d'accouplement opposées (534, 536) qui assurent l'interface avec le contact d'accouplement (134) et un contact central (538) de telle sorte que les interconnexions créent un trajet électrique direct entre les ensembles de contact de face arrière et les ensembles de contact de carte fille, les alésages (520) reçoivent en outre des portions d'ensembles de carte fille correspondantes de telle sorte que des interfaces d'accouplement des ensembles de contact de face arrière (504) et des interfaces d'accouplement des ensembles de carte fille (102) soient positionnées au sein d'alésages correspondants (520).

2. Système de connecteur électrique (10) de la revendication 1, dans lequel les ensembles de contact de face arrière (504) sont chargés par ressort au sein du logement (500) du connecteur de face arrière afin de permettre un mouvement relatif entre les ensembles de contact de face arrière et le logement du connecteur de face arrière.

3. Système de connecteur électrique (10) de la revendication 1, dans lequel les ensembles de contact de face arrière (504) comprennent chacun un ressort (544) entourant la coque externe (540), une première extrémité du ressort se mettant en prise avec le logement (500) du connecteur de face arrière, une deuxième extrémité du ressort se mettant en prise avec une rondelle de retenue couplée à la coque (540), le ressort étant capturé entre le logement du connecteur de face arrière et la rondelle de retenue et étant compressible afin de permettre un mouvement relatif entre les ensembles de contact de face arrière et le logement du connecteur de face arrière.

4. Système de connecteur électrique (10) de la revendication 1, dans lequel les ensembles de contact de face arrière (504) ont chacun des interfaces d'accouplement à l'intérieur du logement (500) du connecteur de face arrière (502).

5. Système de connecteur électrique (10) de la revendication 1, dans lequel les ensembles de contact de carte fille (102) sont directement accouplés à des ensembles de contact de face arrière correspondants (504) au sein du logement (500) du connecteur de face arrière (12), les ensembles de contact de face arrière flottant au sein du logement du connecteur de face arrière afin de s'aligner à et de maintenir la connexion électrique avec les ensembles de contact de carte fille.

6. Système de connecteur électrique (10) de la revendication 1, dans lequel les ensembles de contact de face arrière (504) sont sollicités par ressort contre des ensembles de contact de carte fille correspondants (102) afin de maintenir la connexion électrique avec ceux-ci.

7. Système de connecteur électrique (10) de la revendication 1, comprenant en outre une garniture (400) entre et mise directement en prise avec à la fois le logement (500) du connecteur de face arrière (502) et le logement (100) du connecteur de carte fille (14).

8. Système de connecteur électrique (10) de la revendication 1, dans lequel des trajets électriques sont créés entre les câbles coaxiaux et la carte à circuits de carte fille (18) via les ensembles de contact de face arrière (504) et les ensembles de contact de carte fille (102) .

9. Système de connecteur électrique (10) de la revendication 1, dans lequel les conducteurs centraux (130) sont maintenus au sein du logement du connecteur de carte fille (14) et sont fixés en place relativement au logement du connecteur de carte fille.

10. Système de connecteur électrique (10) de la revendication 1, le contact d'accouplement (134) étant prévu au niveau de l'extrémité d'accouplement (112) du logement (100) du connecteur de carte fille (14), le contact de carte étant prévu au niveau de l'extrémité de montage (112) du logement du connecteur de carte fille configuré pour être monté sur la carte à circuits de carte fille et orienté perpendiculairement de manière générale par rapport à l'extrémité d'accouplement, le contact de carte étant couplé au contact d'accouplement au sein d'alésages correspondants (120) du logement du connecteur de carte fille, le contact de carte s'étendant à partir du logement du connecteur de carte fille et étant configuré pour être terminé sur la carte à circuits de carte fille.

11. Système de connecteur électrique (10) de la revendication 1, dans lequel le logement du connecteur de carte fille inclut des alésages (120) dans celui-ci qui s'étendent entre des extrémités d'accouplement et de montage (110, 112) du logement du connecteur de carte fille, les extrémités d'accouplement et de montage étant perpendiculaires de manière générale l'une à l'autre, les alésages incluant des premiers et deuxièmes segments (122, 124) orientés perpendiculairement de manière générale l'un par rapport à l'autre, les premiers segments s'étendant entre l'extrémité d'accouplement et le deuxième segment, le deuxième segment s'étendant entre l'extrémité de montage et le premier segment, les ensembles de contact de carte fille incluent chacun un contact d'accouplement (134) reçu dans le premier segment correspondant et un contact de carte (136) reçu dans le deuxième segment correspondant, le contact de carte étant couplé au contact d'accouplement au sein d'alésages correspondants de manière générale au niveau de l'intersection entre les premiers et deuxièmes segments.
